Europäisches Patentamt

European Patent Office

Office européen des brevets

(11) Publication number: **0 474 907 A1**

# EUROPEAN PATENT APPLICATION

(21) Application number: **90117671.9**

(22) Date of filing: **13.09.90**

(51) Int. Cl.5: **G01R  31/00**, G01R 31/08, G07C 5/08

(43) Date of publication of application:
**18.03.92 Bulletin  92/12**

(84) Designated Contracting States:
**DE FR GB IT SE**

(71) Applicant: **FUJIKURA LTD.**
**1-5-1 Kiba**
**Koto-ku Tokyo 135(JP)**

(72) Inventor: **Akashi, Kazuya**
**4-14-10 Hiyoshidai, Tomisato-machi**
**Imba-gun, Chiba-ken 286-02(JP)**
Inventor: **Ishida, Kimitaka**
**207 Fujikura Dormitory, 6-4-32 Kiba**
**Koto-ku, Tokyo 135(JP)**
Inventor: **Taguchi, Morihiko**

**1093-23 Oaza Kamekubo, Oimachi**
**Iruma-gun, Saitama-ken 354(JP)**
Inventor: **Wakasa, Kohki**
**203 Tanaka-kohpo 3-6 Kami-shinonome-cho,**
**Minami-ku**
**Hiroshima-shi, Hiroshima-ken 734(JP)**
Inventor: **Ishimaki, Kenichi**
**2-2-26 Naka**
**Satte-shi, Saitama-ken 340-01(JP)**

(74) Representative: **von Bezold, Dieter, Dr. et al**
**Dr. Dieter von Bezold Dipl.-Ing. Peter Schütz**
**Dipl.-Ing. Wolfgang Heusler Brienner Strasse**
**52**
**W-8000 München 2(DE)**

(54) **A diagnostic apparatus for a vehicle network system and a method of diagnosing a vehicle network system.**

(57) A diagnostic apparatus for a vehicle network system comprises a multidrop bus (1) for transmitting data for controlling electric loads of a vehicle, and a plurality of nodes (A to G) connected to the multidrop bus, for controlling the corresponding electric loads of the vehicle, a diagnosis unit (7) electrically connected to two ends (1a, 1b) of the multidrop bus (1) so that the data is transmitted through the multidrop bus (1) therealong in two opposite directions (l, m). The diagnosis unit (7) has a processing block (7) for sending inquiry data to the corresponding nodes (A to G) from the two ends (1a, 1b) of the multidrop bus (1) alternately in the two directions (l, m), receiving response data from the nodes (A to G) and detecting from what nodes the response data is received and is not received to locate a portion or portions of the multidrop bus (1) where trouble has occurred. The detection of trouble in the multidrop bus (1) is made possible when the diagnosis unit (7) is connected to the two ends of the multidrop bus (1).

FIG.4

# FIG.5

This invention relates to a diagnostic apparatus for a vehicle network system and a method of diagnosing a vehicle network system.

Japanese Laid-open Patent Application Publication No. 2-2752 discloses a vehicle network system which comprises a bidirectional multidrop ring formed by connecting together both ends of a multidrop bus used for controlling electric loads of a vehicle such as electric loads of lamps, wipers and a washer. In this network system, data is transmitted from a data-transmitting node to a data-receiving node in two opposite directions along the multidrop ring. Therefore, when some trouble or some problem occurs in the multidrop ring, the data cannot be transmitted in one direction but can be transmitted in the other direction, thereby ensuring safe operation of the system. In other words, trouble such as a breakage in the multidrop ring or disconnection of a connector cannot be found during operation of the system unless it occurs in at least two locations in the multidrop ring.

In order to find the location where trouble has occurred, the overall network system must be carefully checked on a periodical basis. In this case, however, the instrument panel, seats, trim, etc. of a vehicle, through which the network passes, must all be removed. This entails considerable time and effort, and is very costly. Alternatively, the network can be continued to be used until trouble occurs at two locations between different pairs of adjacent nodes in the network. In this case, however, trouble will be found only after it is discovered that important messages are unable to be transmitted through the network, disrupting safe operation of the network. Therefore, these prior arts do not provide effective means of finding trouble in the network.

The object of this invention is to provide a diagnostic apparatus for a vehicle network system and a method of diagnosing a vehicle network system, in which trouble such as the breakage of a wire or disconnection of a connector at one location of a bidirectional multidrop ring can easily be found.

In an aspect of this invention, there is provided a diagnostic apparatus for a vehicle network system, comprising a multidrop bus for transmitting data for controlling electric loads of a vehicle in two opposite directions therealong, a plurality of nodes connected to the multidrop bus for controlling the corresponding loads of the vehicle, and a diagnosis unit electrically connected to the two ends of the multidrop bus and comprising a communication block for sending inquiry data to the corresponding nodes alternately from the two ends of the multidrop bus in the respective two directions and receiving response data from the corresponding nodes, a diagnosis block for detecting from what nodes the communication blocks receive or do not receive the response data and finding the location or locations of the multidrop bus where trouble has occurred. After the diagnosis has been completed, the diagnosis unit is removed from the multidrop bus, and the two ends of the multidrop bus are electrically connected by a connector so that the multidrop bus constitutes a multidrop ring for controlling the electric loads of the vehicle.

In another aspect of this invention, there is provided a method of diagnosing a vehicle network system, comprising the steps of electrically connecting together two ends of a multidrop bus to a diagnosis unit, transmitting inquiry data alternately in two opposite directions from the diagnosis unit to nodes connected to the multidrop bus through the multidrop bus, receiving, by means of the diagnosis unit, response data corresponding to the inquiry data from the corresponding nodes in the two directions, checking whether or not the diagnosis unit receives the response data from the corresponding nodes in at least either one of the two directions, and determining whether trouble has occurred at at least one location of the multidrop bus. Upon finishing diagnosis, the diagnosis unit is replaced by a connector so that the multidrop bus is used as a bidirectional multidrop ring.

This invention will be described in detail by way of embodiments with reference to the accompanying drawings in which:

Fig. 1 is a schematic view of one embodiment of a vehicle network system to which this invention is applied;

Figs. 2 and 3 are schematic side views of embodiments of connectors used for the network system of Fig. 1, when the system is used for controlling electric loads of a vehicle;

Fig. 4 is a schematic view of one embodiment of a diagnosis unit used for the network system of Fig. 1;

Fig. 5 is a schematic view of a diagnostic apparatus constituted by the network system of Fig. 1 and the diagnosis unit of Fig. 4;

Fig. 6 is a schematic view of another embodiment of a diagnosis unit used for the network system of Fig. 1;

Fig. 7 is a schematic view of a further embodiment of a diagnostic apparatus according to this invention; and

Fig. 8 is a schematic view of a still further embodiment which is a combination of a diagnosis unit and a control device for electric loads of a vehicle used in the diagnostic apparatus of Fig. 7.

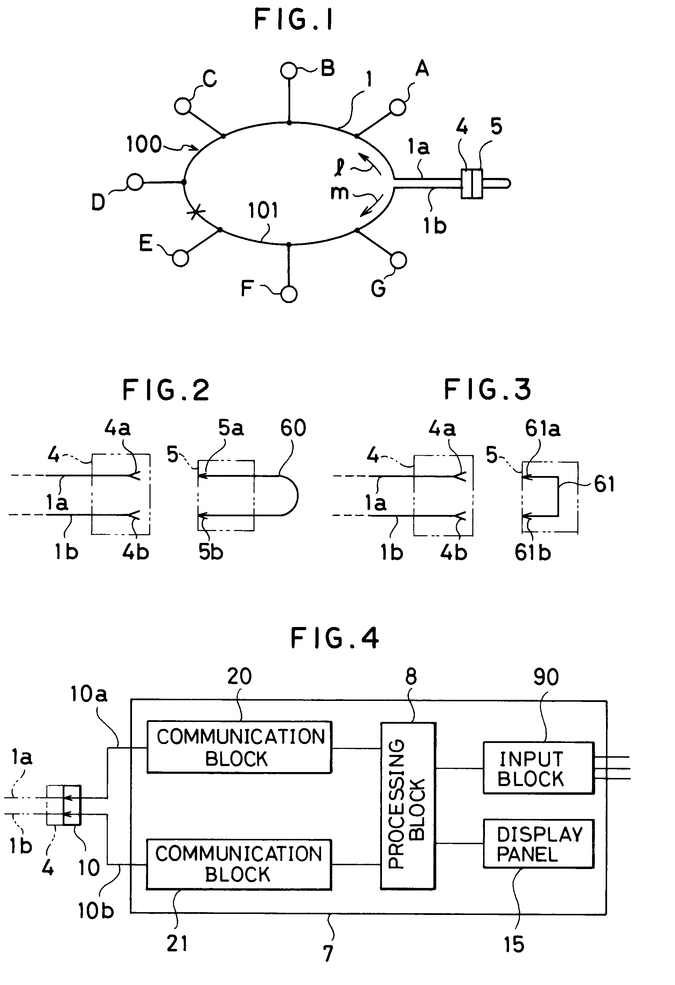

Referring to Figs. 1 to 3, an embodiment of a vehicle network system 100 comprises a multidrop bus 1, nodes or multiunits A, B, C, D, E, F and G electrically connected to the multidrop bus 1 and a bus-side connector 4 electrically connected to both ends 1a and 1b of the multidrop bus 1. When the system 100 is used for controlling electric loads of a vehicle, a short-circuit connector 5 is connected to the bus-side connector 4, so that both ends of the multidrop bus 1 are electrically connected to cause the multidrop bus 1 to function as a bidirectional multidrop ring 101.

The multidrop bus 1 comprises a single wire, a paired wire or a twist wire, shielded or unshielded, or the like.

The nodes or multiunits A to G interchange messages or data through the multidrop ring 101, so as to control electric loads of vehicle devices such as brakes, lamps, wipers and washers and/or to receive signals from the vehicle devices. Assuming that a stop lamp switch is connected to the node A and a stop lamp to the node D, depression of the brake pedal by the driver causes a message or an inquiry data including a signal for lighting the stop lamp to be transmitted from the node A to the node D through the multidrop ring 101. The node D reads the message and supplies power to the corresponding vehicle load in response to the switch signal included in the message, so as to light the lamps. In the nature of the bidirectional multidrop ring, the message is transmitted through the multidrop ring 101 in the two opposite directions l and m, as shown in Fig. 1.

A connector assembly shown in Fig. 2 comprises a bus-side connector or a female connector 4 containing a pair of female terminals 4a and 4b connected to the respect ends 1a and 1b of the multidrop bus 1, and a short-circuit connector or a male connector 5 containing a pair of male terminals 5a and 5b engageable with the respective female terminals 4a and 4b when the short-circuit connector 5 is connected to the bus-side connector 4. A wire 60, the central portion of which extends from the short-circuit connector 5, is connected to the female terminals 5b and 5c at both its ends. The male and female connectors are interchangeable.

Fig. 3 shows another embodiment of a connector assembly which comprises a bus-side connector or a female connector 4 having the same structure as that of Fig. 2, and short-circuit connector or a male connector 5 containing a short bar 61 which extends in the short-circuit connector 5 and is connected at both ends 61a and 61b thereof to the female terminals 4a and 4b.

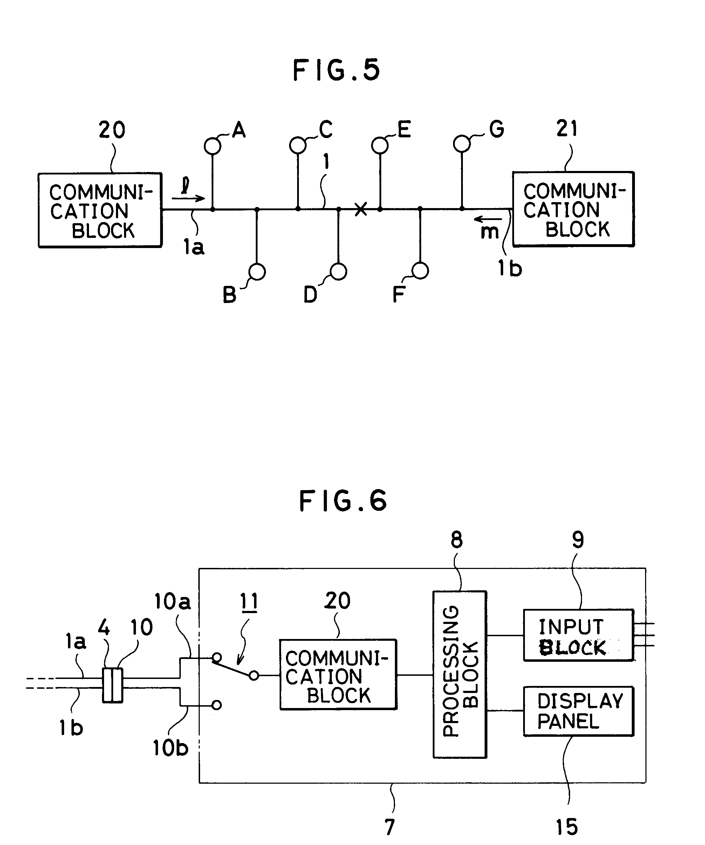

Referring to Figs. 4 and 5, an embodiment of a diagnostic apparatus will now be explained.

Shown in Fig. 4 is a block diagram of a diagnosis unit 7 which comprises a pair of communication blocks 20 and 21, a processing block 8 such as a CPU connected to the communication blocks 20 and 21, an I/O interface comprising an input block 90 connected to the processing block 8, and a display panel 15 such as a CRT or an LCD also connected to the processing block 8, for displaying the result of diagnosis. The communication blocks 20 and 21 are connected, by means of leads 10a and 10b and a diagnosis unit connector 10 coupled with the bus-side connector 4, to the respective ends 1a and 1b of the multidrop bus 1.

Programs for carrying out diagnosis of the vehicle network system are written in ROMs incorporated in the processing block 8. The programs start when a diagnosis start switch (not shown but provided in the diagnosis unit 7) is turned on. Further, the input block 90 is connected to message transmitting elements such as switches, and receives inquiry message therefrom to supply the same to the processing block 8.

With reference to Figs. 4 and 5, the operation of the diagnostic apparatus will now be described.

The short-circuit connector 5 is detached from the bus-side connector 4, and then the diagnosis unit connector 10 is connected thereto such that the bus 1 is connected to the communication blocks 20 and 21 at its respective ends 1a and 1b, as shown in Fig. 5.

Upon turning on the switch (not shown) on the diagnosis unit 7 with the communication block 21 rendered inoperable, the processing block 8 first sends inquiry data from the communication block 20 to the nodes A to G and receives a response therefrom. The inquiry data enters the bus 1 at one end 1a thereof to be transmitted in the direction l and return as the response data in the reverse course of the same route. Thereafter, the communication block 20 is made inoperable and the processing block 8 similarly sends inquiry data from the communication block 21 to the nodes A to G and receives response data therefrom. In this second step, the inquiry data enters the bus 1 at the other end 1b thereof, to be transmitted in the direction m opposite to the direction l, and also return as the response data in the reverse course of the same route.

The diagnosis of trouble in the vehicle network system is effected as follows:

Referring to Fig. 5, it is assumed that when the inquiry data is delivered from the processing block 8 to the bus 1 through the communication block 20, the processing block 8 receives the response data only from A, B, C and D, and, when the inquiry data is sent from the communication block 21, the processing block 8 received the response data only from the nodes E, F and G. Then, the processing block 8 determines that trouble has occurred at the location of the bus 1 between the nodes D and E and displays the trouble on the display panel 15.

Similarly, when the processing block 8 receives the response data only from the node A in response to the inquiry data from the communication block 20 and the response data only from the nodes E, F and G in response to the inquiry data from the communication block 21, the processing block 8 determines that trouble has occurred between the nodes A and B and between the nodes D and E, and displays this fact on the display panel 15.

On the other hand, when the processing block 8 receives the response data from all the nodes A to G in response to the inquiry date from both communication blocks 20 and 21, the processing block 8 determines that the vehicle network system or the multidrop bus 1 is operating normally without any trouble.

As explained above, the diagnostic apparatus according to this embodiment employs a multidrop bus 1 whose both ends 1a and 1b are connected together by a short-circuit connector 5 to form a bidirectional multidrop ring when it is used in a vehicle network system 100 for controlling the electric loads of a vehicle and is connected by a diagnosis unit 7 when it is used in a diagnostic apparatus. To diagnose trouble, inquiry data is transmitted from the diagnosis unit 7 to the nodes A to G through the multidrop bus 1 in two opposite directions l and m, and a location or locations of the multidrop bus 1 where trouble such as the breakage of a wire or wires and/or disconnection of a connector or connectors has occurred are found based on which node or nodes the response data is not returned to the diagnosis unit 7.

In Fig. 6 is shown a second embodiment of the diagnosis unit 7 which employs a single communication block 20. A change-over switch 11 is provided so that change-over is performed between the connection of the communication block 20 to a wire 10a, connected to one end 1a of the multidrop bus 1 through the connectors 10 and 4, and the connection of the communication block 20 to another wire 10b, connected the other end 1b of the multidrop bus 1 through the connectors 10 and 4. The processing block 8, input block 90, and display panel 15 of this embodiment are the same as those of the first embodiment. The merit of this embodiment is that only one communication block 20 is used.

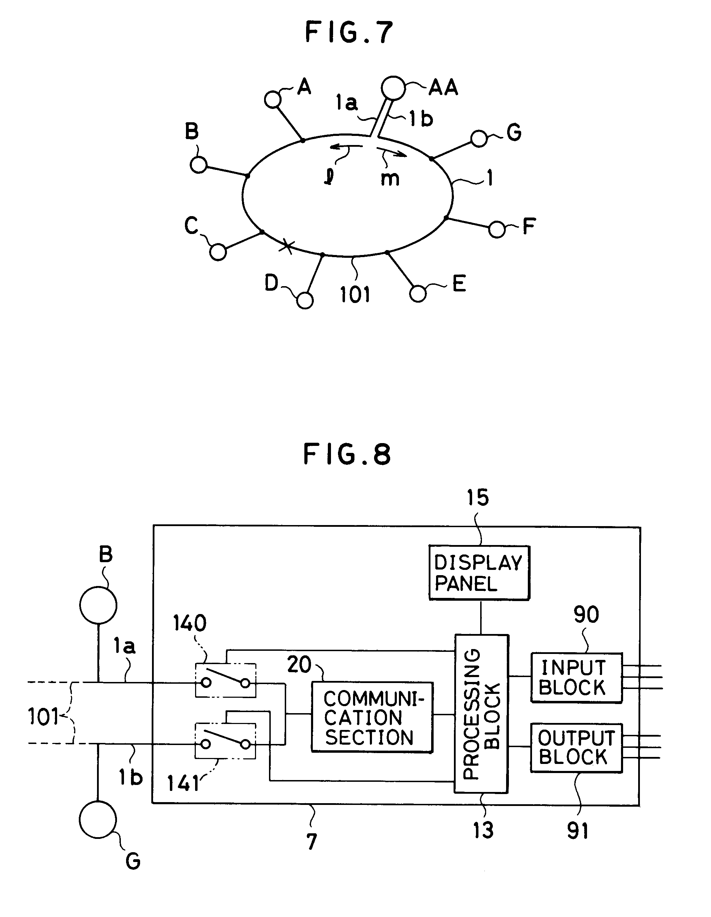

A second embodiment of a diagnostic apparatus used in a vehicle network system is schematically shown in Figs. 7 and 8.

A node or multiunit AA is an on-board diagnosis unit combined with the multidrop bus 1 to form a bidirectional multidrop ring 101 together with nodes having similar functions to the nodes A to G. In other words, the diagnosing block is one of nodes or multiunits. In these two figures, the same reference numerals are given to elements identical to those of the embodiment shown in Figs. 1 and 4, the description thereof being omitted.

Fig. 8 is a schematic view of the node AA which comprises a processing block 13, a communication block 20, an input block 90 and an output block 91 connected to the processing block 13, and a pair of switches 140 and 141 connected to the communication block 20 and the respective ends 1a and 1b of the multidrop bus 1. The processing block 13 not only controls the change-over of the switches 140 and 141 and finds the location or locations where trouble has occurred in a multidrop bus 1, but also controls electric loads of the vehicle.

In a ROM incorporated in the processing block 8 is written not only a program for operating the associated devices of the vehicle but also a diagnosing program which starts when an ignition key is turned to the "on" position.

When the ignition key is turned to the "on" position, the diagnostic operation is carried out at first. The processing block 13 sends a command to close the switch 140 and open the switch 141, so that inquiry data is transmitted in the direction l to the nodes A to G through the bidirectional multidrop ring 101 at one end 1a thereof and receives response data from these nodes. Thereafter, the processing block 13 sends a command to open the switch 140 and close the switch 141, so that inquiry data is sent in the direction m opposite to the direction l to the nodes A to G through the multidrop ring 101 at the other end 1b thereof.

Trouble-finding process is carried out in a similar manner to the process according to the embodiment of Figs. 4 and 5.

For example, let it be assumed that when the inquiry data is supplied from the processing block 8 at one end 1a of the multidrop bus 1 in the direction l, the response data returns only from A, B and C, and then the inquiry data is sent out from the processing block 8 at the other end 1b of the multidrop bus 1 in the direction m, and the response data is sent back from the nodes D, E, F and G. Then, the processing block 8 determines that trouble has occurred between the nodes C and D. Further, let it be assumed that when the inquiry data is sent to the nodes A to G through the switch 140, the response data are sent from the nodes A, B and C, and then when the inquiry data is supplied through the switch 141, the response data is not returned. Then, the processing block 8 determines that trouble has occurred between the nodes C and D and between the nodes AA and G. When the processing block 8 receives the response data from all nodes in both directions, the block determines that the multidrop ring 101 is operating normally.

This second embodiment has the advantage that the diagnosis of the vehicle network system and the control of the electric loads of the vehicle are carried out automatically and continuously, reducing the diagnostic cost. Further, in the second embodiment, the diagnosis is carried out without the need to take the vehicle to a repair shop.

As an alternative to the diagnosis being performed upon turning the ignition key to the "on" position in the second embodiment, the diagnosis can be effected periodically or as when required.

Trouble occurring in the nodes is also detected by the apparatus of the present invention.

In the above-mentioned embodiments, the order in which the inquiry data is sent in the two directions can be changed.

## Claims

1. A diagnostic apparatus for a vehicle network system, comprising a multidrop bus for transmitting data for controlling electric loads of a vehicle and a plurality of nodes connected to said multidrop bus, for controlling the corresponding electric loads of said vehicle,
characterized in that diagnosing means (7) is electrically connected to two ends (1a, 1b) of said multidrop bus (1) so that said data is transmitted through said multidrop bus (1) in two opposite directions (l, m) along said multidrop bus, said diagnosing means (7) comprises means (7) for sending inquiry data to the corresponding nodes (A to G) alternately from said two ends (1a, 1b) of said multidrop bus (1) in said two directions (l, m), receiving response data from said nodes (A to G) and detecting from what nodes said response data is received and is not received to find a location or locations of said multidrop bus (1) where trouble has occurred.

2. The apparatus according to claim 1, characterized in that said diagnosing means (7) comprises communication means (20, 21) for sending and receiving said inquiry data to the corresponding nodes (A to G) and checking means (8, 13) for checking whether said checking means receives said response data to find said location or locations where said trouble has occurred.

3. The apparatus according to claim 2, characterized in that said diagnosing means (7) comprises two communication blocks (20, 21) electrically connected to the respective two ends (1a, 1b) of said multidrop bus (1) and a processing block (8) electrically connected to said communicating blocks for sending said inquiry data and receiving said response data to find said location or locations where said trouble has occurred.

4. The apparatus according to claim 2, characterized in that said diagnosing means (7) comprises a communication block (20) and switch means (11; 140, 141) for electrically connecting said communication block to said two ends (1a, 1b) of said multidrop bus (1).

5. The apparatus according to claim 4, characterized in that said switch means comprises a switch (11) selectively connecting said communication block (20) to said two ends (1a, 1b) of said multidrop bus (1).

6. The apparatus according to claim 4, characterized in that said switch means comprises two switches (140, 141) for connecting said processing block (8) to said two ends (1a, 1b), respectively.

7. The apparatus according to any one of the preceding claims, characterized in that said two ends (1a, 1b) of said multidrop bus (1) are connected by a short-circuit connector (5) when said apparatus is used for controlling said electric loads of said vehicle.

8. The apparatus according to any one of the preceding claims, characterized in that said multidrop bus (1) comprises a single wire.

9. The apparatus according to claim 8, characterized in that said single wire is shielded.

10. The apparatus according to claim 8, characterized in that said single wire is unshielded.

11. The apparatus according to any one of claims 1 to 7, characterized in that said multidrop bus (1) comprises a paired wire.

12. The apparatus according to claim 11, characterized in that said paired wire is shielded.

13. The apparatus according to claim 11, characterized in that said paired wire is unshielded.

14. The apparatus according to claim 11 or claim 12, characterized in that said paired wire is twisted.

15. The apparatus according to any one of claims 1 to 7, characterized in that said multidrop bus (1) is a coaxial cable.

16. A method of diagnosing a vehicle network system, characterized by comprising the steps of:

electrically connecting two ends (1a, 1b) of a multidrop bus (1) to diagnosing means (7);

transmitting inquiry data from said diagnosing means (7) to nodes (A to G) connected to said multidrop bus (1) therethrough in two opposite directions (l, m);

receiving, by means of said diagnosing means (7), response data corresponding to said inquiry data from the corresponding nodes (A to G) alternately in said two directions (l, m);

checking whether or not said diagnosing means (7) receives said response data from said corresponding nodes (A to G) in said two directions (l, m); and

determining that trouble has occurred at at least one location of said multidrop bus (1) from which said response data is not returned.

17. The method according to claim 16, characterized by further comprising the step of connecting together said two ends (1a, 1b) of said multidrop bus (1) by means of a short-circuit connector (5) so that said multidrop bus (1) is used as a bidirectional multidrop ring (101) for controlling electric loads of a vehicle.

## FIG. I

## FIG.2

## FIG.3

## FIG.4

# FIG.5

# FIG.6

## FIG.7

## FIG.8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 231 607 (ZALESKI)<br>* Column 2, line 49 - column 3, line 11, lines 19-32; column 10, lines 28-43; column 13, line 22 - column 14, line 3, line 31 - column 15, line 10; figures 11,14 * | 1,2,4,6,16 | G 01 R 31/00<br>G 01 R 31/08<br>G 07 C 5/08 |
| A | | 5,7 | |
| | − − − | | |
| E | PATENT ABSTRACTS OF JAPAN, vol. 14, no. 576 (E-1016)[4519], 21st December 1990;<br>& JP-A-2 250 536 (FUJIKURA LTD) 08-10-1990 | 1,2,3,16, 17 | |
| | − − − | | |
| A | IEEE NETWORK, vol. 3, no. 6, November 1989, pages 15-19; B. ALLAN: "What managers really need to know about LANs"<br>* Page 17, right-hand column, paragraphs 3,4; page 19, left-hand column, paragraphs 2-4; figures 1,2 * | 8-15 | |
| | − − − | | |
| A | FR-A-2 083 834 (BOSCH)<br>* Page 3, lines 8-35; figure 1 * | 17 | |
| | − − − − − | | |

| TECHNICAL FIELDS SEARCHED (Int. Cl.5) |
|---|
| G 01 R<br>G 07 C |

The present search report has been drawn up for all claims

| Place of search | Date of completion of search | Examiner |
|---|---|---|
| The Hague | 15 May 91 | SINAPIUS G.H. |